# EUROPEAN PATENT APPLICATION

(11) **EP 2 546 623 A2**
(43) Date of publication of application: **16.01.2013**
(21) Application number: 12748373.3
(22) Date of filing: 05.03.2012
(51) Int. Cl.: G01J 5/02, G01J 5/20, H01L 31/101

(54) **INFRARED SENSOR CHIP, INFRARED DETECTOR AND AN OPERATING METHOD AND TEST METHOD THEREFOR**

(30) Priority: 04.03.2011 KR 20110019687
(71) Applicant: Korea Advanced Institute of Science and Technology, Daejeon 305-701 (KR)
(72) Inventor: KIM, Hee Yeoun, Daejeon 305-761 (KR); KIM, Kyoung Min, Daejeon 305-701 (KR); KIM, Byeong Il, Chungcheongnam-do 314-756 (KR); KYUNG, Ki Myeong, Daejeon 305-509 (KR); PARK, Jae Hong, Daejeon 305-755 (KR); LEE, Kwy Ro, Daejeon 305-500 (KR); KIM, Gyung Tae, Daejeon 302-764 (KR)
(74) Representative: Zambardino, Umberto
(86) International application number: PCT/KR2012/001612
(87) International publication number: WO 2012/121526

(57) **Abstract**

According to the embodiment of the present invention, an infrared sensor chip may be provided that includes: a CMOS circuit board comprised of an active matrix, a row line selector and an output multiplexer; and a bolometer which is stacked on the CMOS circuit board and is comprised of an active cell and a reference cell, wherein, for the purpose of a parametric test for the bolometer at a wafer or chip state, the row line selector selects a cell to which a voltage is applied in the bolometer, and wherein the output multiplexer outputs current characteristics according to the voltage application.

## Description

### [Technical Field]

The present invention relates to an infrared sensor chip, an infrared detector and a method for operating and testing the same.

### [Background Art]

A bolometer-type infrared detector has resistance characteristics, varying depending on a temperature. The infrared sensor includes a sensor (for example, a bolometer) and a read out integrated circuit (ROIC) for processing signals according to the amount of infrared rays detected by the sensor.

A conventional infrared detector is manufactured on a wafer substrate by designing in advance the ROIC on the wafer substrate and by using a MEMS process.

Therefore, since the ROIC is designed in advance on the wafer and the sensor is manufactured on the ROIC, it is not easy to previously check the operation state of the sensor.

Also, since the sensor and the ROIC are connected to each other by using a monolithic method, the degree of integration of a chip is low and the wafer and/or the infrared detector cannot be reused when defective, so that there is a disadvantage in that cost is increased.

### [Disclosure]

### [Technical Problem]

The present invention is provided to overcome the above-mentioned problems of the prior art. The present invention removes interference between the bolometer and the ROIC chip and makes it possible to test the wafer or the chip level.

The objective of the present invention is to improve the manufacturing yield through process monitoring and minimize the cost caused by defections by reducing the manufacturing cost of the infrared detector and by checking in advance the operation state of the sensor and/or the ROIC.

### [Technical Solution]

One embodiment is an infrared sensor chip. The infrared sensor chip includes: a CMOS circuit board comprised of an active matrix, a row line selector and an output multiplexer; and a bolometer which is stacked on the CMOS circuit board and is comprised of an active cell and a reference cell, wherein, for the purpose of a parametric test for the bolometer at a wafer or chip level, the row line selector selects a cell to which a voltage is applied in the bolometer, and wherein the output multiplexer outputs current characteristics according to the voltage application.

A first switch and a second switch may be on/off controlled respectively by a control signal. The first switch selectively connects the reference cell with one input terminal of the output multiplexer. The second switch selectively connects the active cell with the one input terminal of the output multiplexer.

When the first switch and the second switch are on/off controlled respectively, a value of current flowing through one of the reference cell and the active cell may be outputted through the output multiplexer.

The first switch which selectively connects the reference cell with one input terminal of the output multiplexer and the second switch which selectively connects the active cell with the one input terminal of the output multiplexer may be controlled by an independent analog control signal and may operate in a saturation area. A difference between currents flowing through the reference cell and the active cell may be inputted as it is or may be amplified by an amplifier and inputted to one input terminal of the output multiplexer.

Another embodiment is a parametric testing method of an infrared sensor including an active cell and a reference cell. The method includes: receiving sequentially values of current flowing through the reference cell and the active cell by controlling in manner that a first switch and a second switch are alternately on/off states, wherein the first switch which selectively connects the reference cell with one input terminal of an output multiplexer and wherein the second switch which selectively connects the active cell with the one input terminal of the output multiplexer; and measuring resistance values of the reference cell and the active cell on the basis of the current values and a voltage applied to both ends of the reference cell and the active cell.

An independent variable analog power control signal for the on/off control may be inputted to the first switch and the second switch respectively.

Further another embodiment is an operating method of an infrared sensor including an active cell and a reference cell. The method includes: applying an independent variable analog power control signal to a first switch which selectively connects the reference cell with one input terminal of an output multiplexer; applying an independent variable analog power control signal to a second switch which selectively connects the active cell with the one input terminal of the output multiplexer; and outputting externally a difference between currents flowing through the reference cell and the active cell through the output multiplexer such that the difference is outputted as it is or is amplified and outputted.

Yet another embodiment is an infrared detector including: an infrared sensor chip which includes a circuit board including a row line selector and an output multiplexer, an infrared sensor which is stacked on the circuit board and includes a plurality of cells which are selected by a signal from the row line selector and output a current signal related to infrared detection to the output multiplexer; and a Sa-FPA controller chip which is electrically connected to the infrared sensor chip and applies a signal controlling the row line selector and the output multiplexer, and reads the current signal transmitted from the output multiplexer.

The Sa-FPA controller chip may be integrated with an image signal processing (ISP) chip.

The Sa-FPA controller chip may be integrated with a DAC variable analog power chip.

### [Advantageous Effects]

According to the present invention, an infrared sensor chip without a Sa-FPA controller chip is separately manufactured, so that a bolometer of a wafer or a chip level can be tested, and thus it is possible to minimize the cost caused by defections.

Also, according to the present invention, it is possible to reduce the manufacturing cost of the infrared detector and to shorten time required for developing the infrared detector. The manufacturing yield can be also improved through process monitoring.

### [Description of Drawings]

Fig. 1 is a conceptual diagram for schematically describing a configuration of an infrared detector using Sa-FPA according to an embodiment of the present invention;
Fig. 2 is a flowchart showing a manufacturing process of the infrared detector using Sa-FPA according to the embodiment of the present invention;
Figs. 3 and 4 are block diagrams showing the manufacturing process one by one of the infrared detector using Sa-FPA according to the flowchart of Fig. 2;
Fig. 5 is a circuit diagram showing the configuration of the infrared detector according to the embodiment of the present invention;
Fig. 6 is a circuit diagram of a row control shift register in the circuit diagram shown in Fig. 5;
Fig. 7 is a circuit diagram of a column control shift register in the circuit diagram shown in Fig. 5;
Fig. 8 is another circuit diagram of an infrared sensor chip according to the embodiment of the present invention;
Fig. 9 is a block diagram for describing the operation mode and test mode of the infrared sensor chip according to the embodiment of the present invention;
Figs. 10 and 11 are circuit diagrams showing configurations of the infrared sensor and an output multiplexer in the block diagram of Fig. 9; and
Fig. 12 is a circuit diagram showing signal flows when the circuit diagram of Fig. 10 is in an operation mode.

### [Mode for Invention]

As the present invention can have various embodiments as well as can be diversely changed, specific embodiments will be illustrated in the drawings and described in detail. While the present invention is not limited to particular embodiments, all modification, equivalents and substitutes included in the spirit and scope of the present invention are understood to be included therein. In the drawings, similar reference numerals are used to designate similar components. While terms such as the first and the second, etc., can be used to describe various components, the components are not limited by the terms mentioned above. The terms are used only for distinguishing between one component and other components. For example, the first component may be designated as the second component without departing from the scope of rights of the invention. Similarly, the second component may be designated as the first component. The term of 'and/or' includes a combination or one of a plurality of related items mentioned.

In the case where a component is referred to as being "connected" or "accessed" to other component, it should be understood that not only the component is directly connected or accessed to the other component, but also there may exist another component between them. Meanwhile, in the case where a component is referred to as being "directly connected" or "directly accessed" to other component, it should be understood that there is no component therebetween.

Terms used in the present specification are provided for description of only specific embodiments of the present invention, and not intended to be limiting. An expression of a singular form includes the expression of plural form thereof unless otherwise explicitly mentioned in the context. In the present specification, it should be understood that the term "include" or "comprise" and the like is intended to specify characteristics, numbers, steps, operations, components, parts or any combination thereof which are mentioned in the specification, and intended not to previously exclude the possibility of existence or addition of at least one another characteristics, numbers, steps, operations, components, parts or any combination thereof.

Unless differently defined, all terms used herein including technical and scientific terms have the same meaning as commonly understood by one of ordinary skill in the art to which the present invention belongs. Terms, for example, commonly used terms defined in the dictionary, are to be construed to have exactly the same meaning as that of related technology in the context. As long as terms are not clearly defined in the present application, the terms should not be ideally or excessively construed as formal meaning.

Hereafter, an infrared detector which is manufactured by using Sa-FPA according to an embodiment of the present invention and a method for manufacturing the same will be described in detail.

### Entire configuration of infrared detector

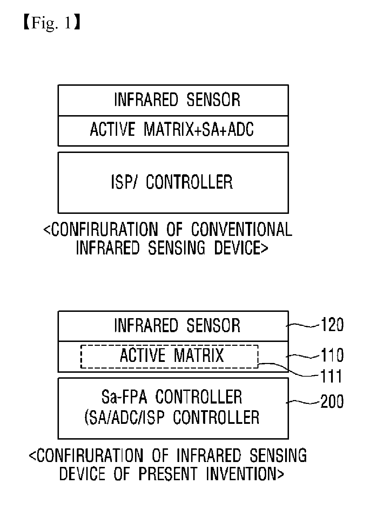

Fig. 1 is a conceptual diagram for schematically describing the entire configuration of an infrared detector using Sa-FPA according to an embodiment of the present invention as well as the entire configuration of a conventional infrared detector.

Referring to Fig. 1, the infrared detector according to the embodiment of the present includes an infrared sensor chip 100 including a bolometer 120 formed on a basic logic/switch circuit board 110, and a Sa-FPA controller chip 200 connectable to the infrared sensor chip 100.

The basic logic/switch circuit board 110 of the infrared sensor chip 100 includes an active matrix 111. The basic logic/switch circuit board 110 may also include a row line selector and an output multiplexer, which are intended to select each cell of the bolometer 120 formed on the active matrix and to detect signals output from the cell. Specifically, the row line selector applies electric power (for example, voltage and the like) to each cell of the bolometer 120. The output multiplexer receives a response (for example, current characteristics) according to the power application and outputs the response. The detailed configurations of the row line selector, the output multiplexer and the bolometer 120 formed on the active matrix will be described later.

In the infrared detector according to the present invention, only the active matrix and essential circuit for selecting the cell of the bolometer 120 are formed on the basic logic/switch circuit board 110 of the infrared sensor chip 100. That is, a sense amplifier (SA) and an analog to digital converter (ADC), both of which have been included in a read out integrated circuit (ROIC) on a conventional infrared sensor chip 100, are separated from the infrared sensor chip 100, and then a separate Sa-FPA controller chip 200 is formed.

In this case, the basic logic/switch circuit board 110 can be implemented by an inexpensive CMOS wafer having a digital logic circuit performing only a function of the active matrix. Therefore, manufacturing cost can be significantly reduced. An electrical evaluation for each cell of the bolometer 120 may be performed at a wafer level. Briefly describing the evaluation method, a voltage is applied to each bolometer 120 and the current characteristics are measured, so that a parametric test can be performed at a wafer or chip level. This will be described later in detail.

The bolometer 120 is stacked on the basic logic/switch circuit board 110 through a micro electro mechanical systems (MEMS) process and the like. The bolometer 120 may be stacked in a monolithic manner.

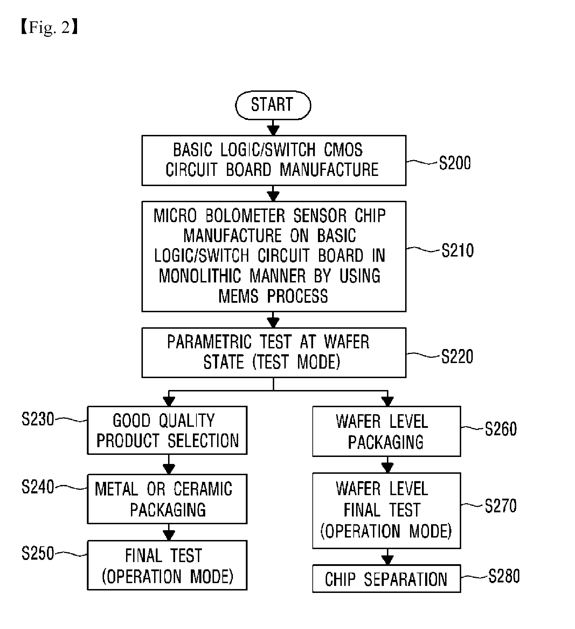

Fig. 2 is a flowchart showing a manufacturing process of the infrared detector using Sa-FPA according to the embodiment of the present invention.

Referring to Figs. 1 and 2, a basic logic/switch circuit board 110 is manufactured and provided (S200) by designing a basic logic/switching element on a wafer (not shown) in advance.

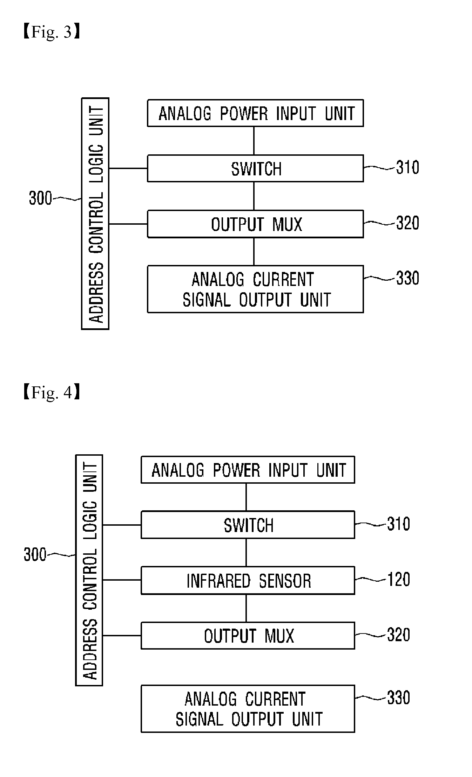

Fig. 3 is a view schematically showing a configuration of the basic logic/switch circuit board 110.

Referring to Fig. 3, the basic logic/switch ciruit board 110 includes a variable analog power input unit like an external D/A converter, a switching unit 310 which is connected to the variable analog power input unit and is comprised of switching elements and the like, an output multiplexer 320 which is connected to the switching unit 310 and selects a part of a plurality of current signals generated from the bolometer to be later deposited, an analog current signal output unit 330 which transmits the current signal to the outside of the chip through the output multiplexer 320, and an address control logic unit 300 which controls the switching unit 310. The address control logic unit 300 is able to function as the above-mentioned row line selector and output multiplexer.

Here, the switching unit 310 may be implemented by a switching element such as NMOS transistor, PMOS transistor, CMOS transistor and the like. Also, the address control logic unit 300 may be implemented by a shift register for sequentially applying addresses to the switching unit 310 and by a multiplexer and the like for randomly applying addresses.

Referring back to Figs. 1 and 2, the bolometer 120 is stacked on the basic logic/switch circuit board 110 in a monolithic manner (S210). This is shown in Fig. 4.

That is, referring to Fig. 4, the bolometer 120 is connected to the switching unit 310 and is also connected to the output multiplexer 320. With this, the infrared sensor chip 100 is manufactured. It can be said that a portion of the basic logic/switch circuit board 110, in which the bolometer 120 is formed corresponds to the above-mentioned active matrix.

Referring back to Fig. 2, a parametric test for the bolometer 120 is performed at a wafer level (S220). As described above, in the present invention, the test can be performed at the wafer level by applying a voltage to an active cell and reference cell, both of which constitute the bolometer 120, and by measuring current characteristics for this voltage application. The test performed in step 220 will be described in detail later.

After the test is completed, good quality products are selected (S230) and packaged (S240), and thus a final test for the infrared sensor chip can be performed (S250). The test performed in step 250 can be said to be an operation mode. This will be described in detail later.

After the test in step 220 is completed, a packaging process at the wafer level (S260), a final test at the wafer level (S270) and a chip separation process (S280) may be performed. The test in step 270 may be performed in the same manner as that of the test in step 250.

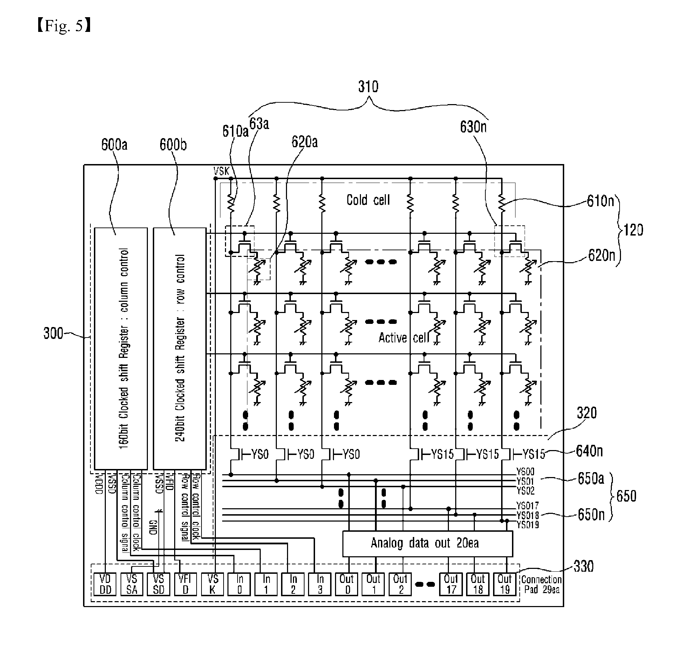

Fig. 5 is a CMOS circuit diagram showing a configuration of the infrared detector using the Sa-FPA according to the embodiment of the present invention.

In other words, Fig. 5 shows a circuit diagram generated by Figs. 1 to 4.

Referring to Fig. 5, the bolometer 120 includes reference cell bolometers 610a to 610n and/or active cell bolometers 620a to 620n. The reference cell bolometers 610a to 610n and/or active cell bolometers 620a to 620n are arranged in the form of an array of columns and rows. The reference cell bolometers 610a to 610n are connected to column lines respectively and the active cell bolometers 620a to 620n are connected to row lines respectively.

Here, first bolometer switching devices 630a to 630n are connected to the bolometers 620a to 620n respectively and control the on/offs of the bolometers 620a to 620n respectively. For the purpose of controlling the on/offs of the first bolometer switching devices 630a to 630n, a column line control shift register 600a, a row line control shift register 600b and column line selection switches 640a to 640n are provided and configured.

The column line control shift register 600a is a 16-bit shift register and makes it possible for the column line selection switches 640a to 640n to sequentially select the column lines by sequentially applying addresses to the column line selection switches 640a to 640n. The row line control shift register 600b is a 240-bit shift register and sequentially applies an address to each row line, so that the active cell bolometers 620a to 620n in a corresponding row line can be on/off controlled. The column line selection switches 640a to 640n can be said to correspond to the above-mentioned output multiplexer.

Also, it is also possible that a certain number of the column line selection switches 640a to 640n may form a block and operated at the same time. For example, 20 column line selection switches 640a to 640n may form one block.

Therefore, during a time period when one row line is in an enable-state by the row line control shift register 600b, the column line control shift register 600a causes the column line selection switches 640a to 640n to become sequentially in the enable-state one by one. Here, the total period of time required for all of the column line selection switches 640a to 640n to become sequentially in the enable-state is the same as a period of time during which one row line is in the enable-state.

The column line selection switches 640a to 640n are connected to routing lines 650a to 650n. Therefore, the electrical signals generated by the bolometers 620a to 620n are externally outputted through the analog current signal output unit 330.

For this purpose, output pads (Out 0 to Out 19) are formed in the analog current signal output unit 330.

A parametric measurement can be performed for the resistance values of all the reference cells 610a to 610n and active cells 620a to 620n by connecting an external test equipment (for example, Agilent 4072A & UF3000) to the analog current signal output unit 330. Through this, statistical process monitoring can be performed.

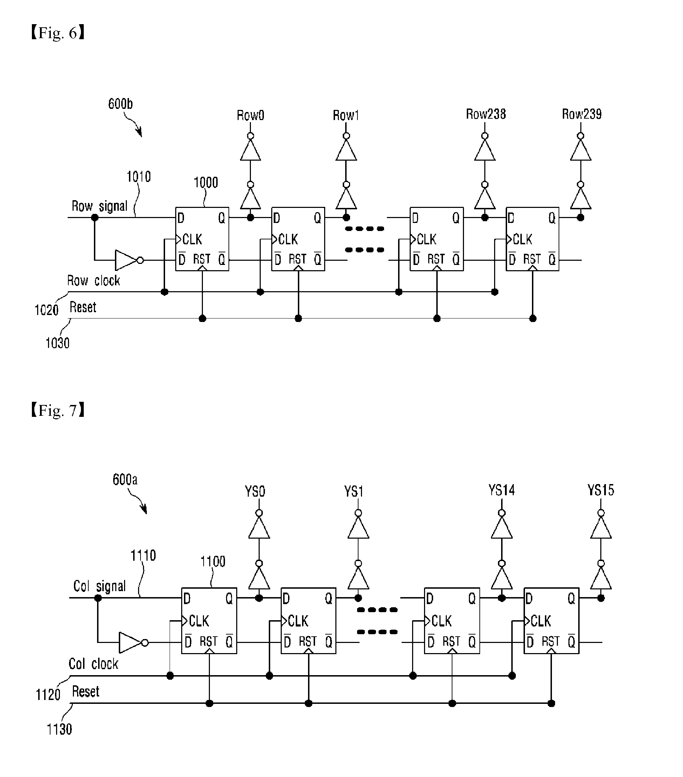

Fig. 6 is a circuit diagram of the row control shift register 600b in the circuit diagram shown in Fig. 5. Referring to Fig. 6, the row control shift register 600b may be comprised of 240 flip-flops 1000. The flip-flop 1000 may be implemented by D-flipflop. However, the present invention is not limited to this and is able to utilize other kinds of flip-flops.

The flip-flop 1000 is connected to a row signal line 1010, a row clock line 1020 and a reset line 1030. As shown in Fig. 5, control signals such as row signal, row clock, reset and the like are inputted through the lines 1010, 1020 and 1030 connected to the analog current signal output unit 330.

Fig. 7 is a circuit diagram of the column control shift register in the circuit diagram shown in Fig. 5. Referring to Fig. 7, the column control shift register 600b may be comprised of 16 flip-flops 1100. The flip-flop 1100 may be implemented by D-flipflop. However, the present invention is not limited to this and is able to utilize other kinds of flip-flops.

The flip-flop 1100 is connected to a column signal line 1110, a row clock line 1120 and a reset line 1130.

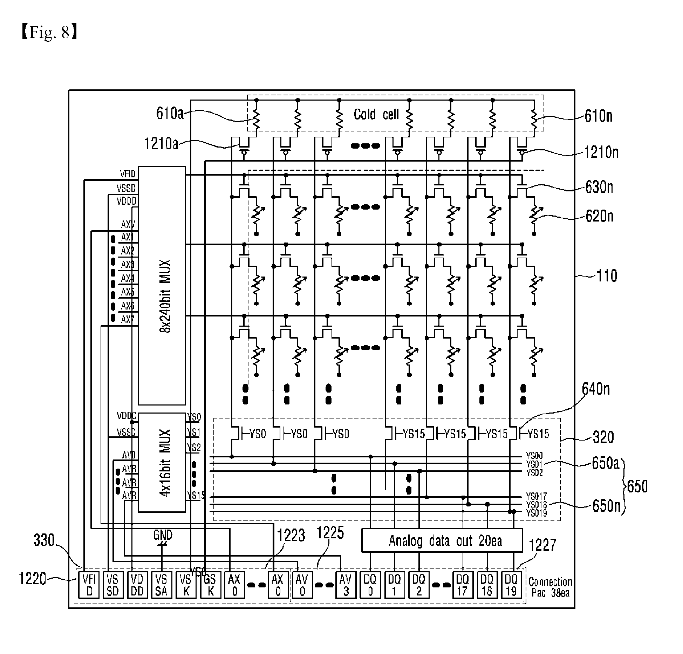

Fig. 8 is another circuit diagram showing a configuration of the infrared detector using Sa-FPA according to another embodiment of the present invention. Unlike Fig. 5, Fig. 8 shows characteristics that addresses are applied to the row line and column line which form an array having a predetermined size (for example, 320 × 240) by using multiplexers 1200a and 1200b instead of the shift registers 600a and 600b.

The column line control multiplexer 1200a is comprised of the multiplexer MUX (for example, a 4 × 6 bit multiplexer) and selectively applies addresses to the column line, so that the column line selection switches 640a to 640n of the corresponding column line is on/off controlled.

The row line control multiplexer 1200b is comprised of the multiplexer MUX (for example, a 8× 240 bit multiplexer) and selectively applies addresses to the row line, so that the bolometer switching devices 630a to 630n of the corresponding row line is on/off controlled.

Therefore, unlike Fig. 5, the bolometer switching devices 630a to 630n can be randomly and selectively tested. In other words, addresses are selectively applied to the column line and/or row line, so that one cell (that is, one bolometer) can be randomly selected and tested. It is also possible to sequentially select the cells and test them as shown in Fig. 5.

Accordingly, during a period of time when one row line is in an enable-state by the row line control multiplexer 1200b, the column line control multiplexer 1200a causes the column line selection switches 640a to 640n to become sequentially in the enable-state one by one. Here, the total period of time required for all of the column line selection switches 640a to 640n to become sequentially in the enable-state is the same as a period of time during which one row line is in the enable-state.

Also, in Fig. 8, the reference cell bolometers 610a to 610n include inverting switching devices 1210a to 1210n. PMOS transistor and the like may be used as the inverting switching devices 1210a to 1210n.

A first column line connection pad 1225 and a second row line connection pad 1223 may be formed in the analog current signal output unit 330 in order to directly select the column line and/or row line. Also, the analog current signal output unit 330 as an external connection pad includes a first input control signal connection pad 1220 and a first signal output connection pad 1227 and the like. The first input control signal connection pad 1220 inputs control signals for the multiplexers 1200a and 1200b and the inverting switching devices 1210a to 1210n. The first signal output connection pad 1227 outputs electrical signals (that is, analog data) generated from the bolometer 610a to 610n and/or 630a to 630n.

The first signal output connection pads 1227 are connected one to one corresponding to the routing lines 650a to 650n.

Hereafter, the operation mode and test mode of the infrared detector using the Sa-FPA according to the embodiment of the present invention will be described.

### Operation mode and test mode of the infrared sensor

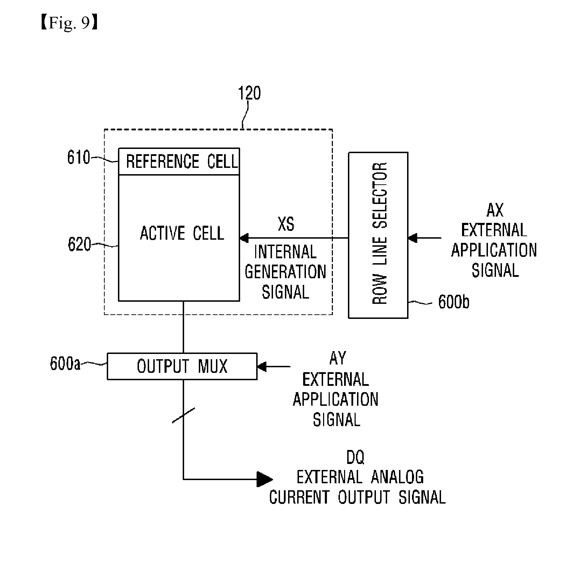

Fig. 9 is a block diagram for describing the operation mode and test mode of the infrared detector according to the embodiment of the present invention.

Referring to Figs. 5 and 9, the bolometer 120 is formed of a pixel array. The pixel array is comprised of the reference cell 610 and the active cell 620.

The row line selector 600b can be said to correspond to the row line control shift register 600b of Fig. 5. The output multiplexer 600a can be said to have a concept covering both the column control shift register 600a of Fig. 5 and the output multiplexer 320 controlled by the column control shift register 600a.

As described above, the output multiplexer 600a and the row line selector 600b are formed in the basic logic/switch circuit board 110.

As described above, the row line selector 600b may receive an external application signal AX generated from the external Sa-FPA controller chip 200 or a tester. The external application signal AX from the external Sa-FPA controller chip 200 may be transmitted to the infrared sensor chip 100. The row line selector 600b receives the external application signal AX and generates an internal signal XS corresponding to the external application signal AX. Each of cells constituting the active cell 620 can be on/off controlled by the internal signal XS.

The output multiplexer 600a may also receive an external application signal AY. The external application signal AY may be also transmitted from the external Sa-FPA controller chip 200 or the tester. The output multiplexer 600a may be implemented by a multiplexer MUX having a predetermined size. Each multiplexer MUX may be selected according to the external application signal AY.

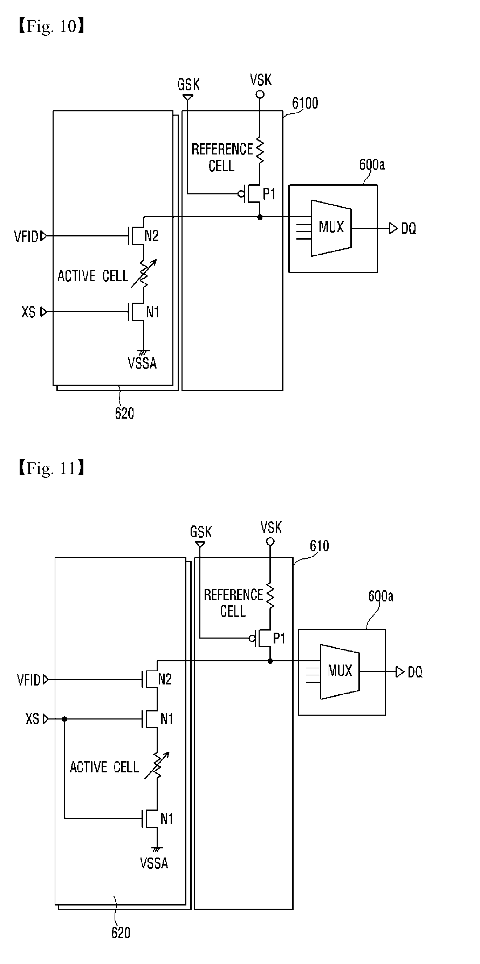

Figs. 10 and 11 are circuit diagrams showing configurations of the bolometer 120 and the output multiplexer 600a in the block diagram of Fig. 9.

Referring to Figs. 10 and 11, one end of the reference cell 610 is connected to a first terminal VSK, and the other end of the reference cell 610 may be selectively connected to the output multiplexer 600a. Variable analog power controlled by DAC may be applied to the first terminal VSK from outside of the chip. However, there is no limit to this. For example, the variable analog power may be supplied from the external Sa-FPA controller chip 200 (see Fig. 1). Here, the Sa-FPA controller chip 200 may be integrated with the DAC variable analog power chip.

The reference cell 610 and the output multiplexer 600a may be selectively connected with each other by a first switch P1. One end of the first switch P1 is connected to one end of the reference cell 610, and the other end of the first switch P1 is connected to one input terminal of the output multiplexer 600a and may be on/off controlled according to a control signal GSK. The control signal GSK may be an analog power control signal controlled by DAC from outside of the chip. However, there is no limit to the control signal GSK.

One end of the active cell 620 may be selectively connected to a second terminal VSSA, and the other end of the active cell 620 may be selectively connected to the other end of the first switch P1. Analog power controlled by DAC from outside of the chip may be applied to the second terminal VSSA. However, there is no limit to this.

One end of the active cell 620 and the second terminal VSSA may be selectively connected with each other by a second switch N1. The second switch N1 may be on/off controlled according to a control signal XS. The other end of the active cell 620 and the other end of the first switch P1 may be connected with each other by a third switch N2. The third switch N2 may be on/off controlled according to a control signal VFID. The control signal VFID may be an analog control signal controlled by DAC from outside of the chip. However, there is no limit to the control signal VFID.

The other end of the active cell and the other end of the reference cell may be inputted to one input terminal of the output multiplexer 600a in accordance with the on/offs of the first switch P1, the second switch N1 and the third switch N2.

The first switch P1, the second switch N1 and the third switch N2 may be implemented by a transistor or another switch device different from the transistor. The first switch P1 may be implemented by PMOS transistor, and the second switch N1 and the third switch N2 may be implemented by NMOS transistor, and vice versa. Hereafter, provided is an example of a case where the first switch P1 is implemented by PMOS transistor, and the second switch N1 and the third switch N2 are implemented by NMOS transistor. When the first switch P1 is implemented by NMOS transistor, and the second switch N1 and the third switch N2 are implemented by PMOS transistor, the signals VSK, GSK, VFID, XS and VSSA should be also described in correspondence to the case. The signals VSK, GSK, VFID, XS and VSSA may be analog control signals controlled by DAC from outside of the chip. However, there is no limit to the signals VSK, GSK, VFID, XS and VSSA. In other words, if a digital high signal is inputted to the first terminal VSK in the following description, a digital low signal should be input to the first terminal VSK in the counterpart case (i.e., PMOS and NMOS are mutually alternated).

Hereafter, signal characteristics in an operation mode and test mode will be described with reference to Figs. 10 and 11.

### Operation mode

In the operation mode, an external voltage is independently applied to the reference cell 610 and the active cell 620, and a difference between signal currents flowing through the cells 610 and 620 is outputted as it is or is amplified and outputted.

Referring to Figs. 10 and 11, a digital high signal as the control signal XS may be inputted to the second switch N1 connected to the active cell 620 needs activating. Analog power controlled by the external D/A converter is inputted to the first terminal VSK. The second terminal VSSA may receive a low signal or may be connected to the ground. Analog power controlled by an appropriate external D/A converter may be inputted as control signals VFID and GSK of the first switch P1 and the third switch N2.

Here, a current having a predetermined magnitude flows through the reference cell 610 and the active cell 620 respectively in accordance with the control signals VFID and GSK applied to the first switch P1 and the third switch N2.

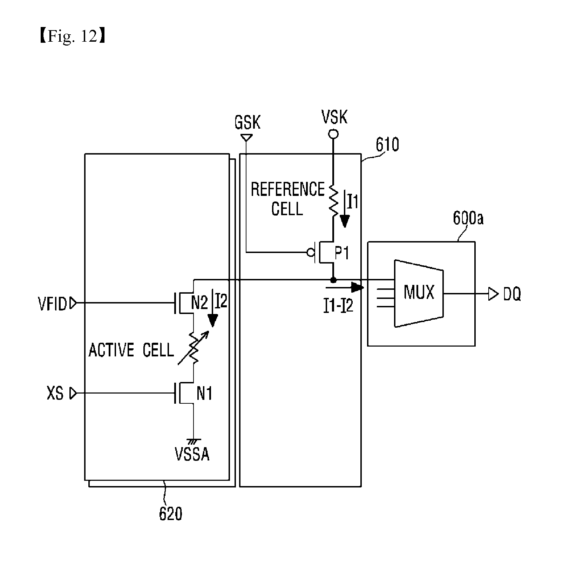

Fig. 12 is a circuit diagram showing current flows when the circuit diagram of Fig. 10 is in an operation mode, the first switch P1 and the third switch N2 operate in a saturation area of the transistor, and the second switch N1 operates in a linear area of the transistor.

Referring to Fig. 12, the first switch P1 and the third switch N2 operate in a saturation area of the transistor. The second switch N1 operates in a linear area of the transistor. Here, a difference I1-I2 between current I1 flowing through the reference cell 610 and current 12 flowing through the active cell 620 is inputted to one input terminal of the output multiplexer 600a. The current difference I1-I2 may be inputted as it is or may be amplified by a simple current amplifier and inputted. That is, a simple amplifier, for example, a current amplifier (not shown) using a current mirror may be further formed in the front end of the output multiplexer 600a.

The output multiplexer 600a may output a corresponding input signal according to the external application signal AY.

Meanwhile, a device (not shown) for amplifying the current difference may be further included in the front end of the input terminal of the output multiplexer 600a.

### Test mode

In the test mode, resistance values of the reference cell 610 and the active cell 620 are measured respectively and a statistical monitoring is performed. It is judged whether the sensor is defective or not, and then a good die is selected.

Referring to Figs. 10 and 11, a digital high signal as the control signal XS may be inputted to the second switch N1 connected to the active cell 620 which is a test object.

First, in order to measure the resistance value of the reference cell 610, a digital high signal is inputted to the first terminal VSK, and a low signal may be inputted as the control signals GSK and VFID of the first switch P1 and the third switch N2. Thus, the first switch P1 becomes in an ON-state and the third switch N2 becomes in an OFF-state. In this case, the value of current flowing through the reference cell 610 may be inputted to one input terminal of the output multiplexer 600a, and the input value maybe outputted from the output multiplexer 600a by the external application signal AY. Since the value of voltage applied to both ends of the reference cell 610 is known, the resistance value of the reference cell 610 can be obtained through the signal outputted through the output multiplexer 600a, that is, the value of current flowing through the reference cell 610. Here, ON-resistance of the first switch should be much less than the resistance of the reference cell 610.

Meanwhile, in order to measure the resistance value of the active cell 620, a digital high signal may be inputted as the control signals GSK and VFID of the first switch P1 and the third switch N2. The second terminal VSSA may receive a low signal or may be connected to the ground. Based on the signal application, the first switch P1 becomes in an OFF-state and the third switch N2 becomes in an ON-state. That is, the first switch P1 and the third switch N2 operate in a linear area of the transistor. Since a high signal as the control signal XS is inputted to the second switch N1 connected to the active cell 620 which is a test object, the value of current flowing through the active cell 620 may be inputted to one input terminal of the output multiplexer 600a, and the input value may be outputted from the output multiplexer 600a by the external application signal AY. Since the value of voltage applied to both ends of the active cell 620 is known, the resistance value of the active cell 620 can be obtained through the signal outputted through the output multiplexer 600a, that is, the value of current flowing through the active cell 620. Here, ON-resistances of the second switch and the third switch should be much less than the resistance of the active cell 620.

When the resistance value measurement of the reference cell 610 and the active cell 620 is completed in such a manner described above, it can be seen that whether the sensor is defective or not and statistical resistance distribution is obtained. Through this, only good quality die can be selected and packaged and statistical process monitoring by a parametric testing can be performed. As a result, manufacturing cost and time required for developing can be remarkably reduced.

## Claims

1. An infrared sensor chip comprising:
a CMOS circuit board comprised of an active matrix, a row line selector and an output multiplexer; and
a bolometer which is stacked on the CMOS circuit board and is comprised of an active cell and a reference cell,
wherein, for the purpose of a parametric test for the bolometer at a wafer or chip level, the row line selector selects a cell to which a voltage is applied in the bolometer, and wherein the output multiplexer outputs current characteristics according to the voltage application.

2. The infrared sensor chip of claim 1, wherein a first switch and a second switch are on/off controlled respectively by a control signal, wherein the first switch selectively connects the reference cell with one input terminal of the output multiplexer, and wherein the second switch selectively connects the active cell with the one input terminal of the output multiplexer.

3. The infrared sensor chip of claim 2, wherein, when the first switch and the second switch are on/off controlled respectively, a value of current flowing through one of the reference cell and the active cell is outputted through the output multiplexer.

4. The infrared sensor chip of claim 1, wherein the first switch which selectively connects the reference cell with one input terminal of the output multiplexer and the second switch which selectively connects the active cell with the one input terminal of the output multiplexer are controlled by an independent analog control signal and operate in a saturation area, and wherein a difference between currents flowing through the reference cell and the active cell is inputted as it is or is amplified by an amplifier and is inputted to the one input terminal of the output multiplexer.

5. A parametric testing method of an infrared sensor comprising an active cell and a reference cell, the method comprising:
receiving sequentially values of current flowing through the reference cell and the active cell by controlling in such a manner that a first switch and a second switch are alternately on/off states, wherein the first switch which selectively connects the reference cell with one input terminal of an output multiplexer and wherein the second switch which selectively connects the active cell with the one input terminal of the output multiplexer; and
measuring resistance values of the reference cell and the active cell on the basis of the current values and a voltage applied to both ends of the reference cell and the active cell.

6. The method of claim 5, wherein an independent variable analog power control signal for the on/off control is inputted to the first switch and the second switch respectively.

7. An operating method of an infrared sensor comprising an active cell and a reference cell, the method comprising:
applying an independent variable analog power control signal to a first switch which selectively connects the reference cell with one input terminal of an output multiplexer;
applying an independent variable analog power control signal to a second switch which selectively connects the active cell with the one input terminal of the output multiplexer; and
outputting externally a difference between currents flowing through the reference cell and the active cell through the output multiplexer such that the difference is outputted as it is or is amplified and outputted.

8. An infrared detector comprising:
an infrared sensor chip which includes a circuit board including a row line selector and an output multiplexer, an infrared sensor which is stacked on the circuit board and includes a plurality of cells which are selected by a signal from the row line selector and output a current signal related to infrared detection to the output multiplexer; and
a Sa-FPA controller chip which is electrically connected to the infrared sensor chip and applies a signal controlling the row line selector and the output multiplexer, and reads the current signal transmitted from the output multiplexer.

9. The infrared detector of claim 8, wherein the Sa-FPA controller chip is integrated with an image signal processing (ISP) chip.

10. The infrared detector of claim 8, wherein the Sa-FPA controller chip is integrated with a DAC variable analog power chip.
